# EUROPEAN PATENT SPECIFICATION

(11) **EP 2 523 038 B1**
(45) Date of publication and mention of the grant of the patent: **03.08.2016**
(21) Application number: 12167751.2
(22) Date of filing: 11.05.2012
(51) Int. Cl.: G02F 1/1335, G02B 5/30

(54) **Color filter substrate capable of polarizing and manufacturing method thereof**
Polarisierfähiges Farbfiltersubstrat und Herstellungsverfahren dafür
Substrat de filtre de couleur capable de polariser et son procédé de fabrication

(30) Priority: 13.05.2011 CN 201110124682
(43) Date of publication of application: 14.11.2012
(73) Proprietor: BOE Technology Group Co., Ltd., Beijing 100015 (CN)
(72) Inventor: Yao, Qi, 100176 Beijing (CN); Cao, Zhanfeng, 100176 Beijing (CN); Dai, Tianming, 100176 Beijing (CN); Zhang, Feng, 100176 Beijing (CN); Xu, Chuanxiang, 100176 Beijing (CN)
(74) Representative: Brötz, Helmut

(56) References cited:
- US-A1- 2006 061 519
- US-A1- 2008 100 779
- US-A1- 2009 290 105

## Description

### BACKGROUND

Embodiments of the present disclosure relate to a liquid crystal display, and in particular, to a color filter substrate and a method of manufacturing a color filter substrate.

Thin film transistor liquid crystal displays (TFT-LCDs) have become the mainstream of flat panel displays, and have the advantages of low power consumption, relatively low cost, and substantially no radiation. The display principle of the TFT-LCDs is that, by way of the dielectric anisotropic and conductive anisotropic properties of liquid crystal molecules, the orientation state of liquid crystal molecules can be changed under an applied external electrical field, which in turn leads to the change of the light transmittance.

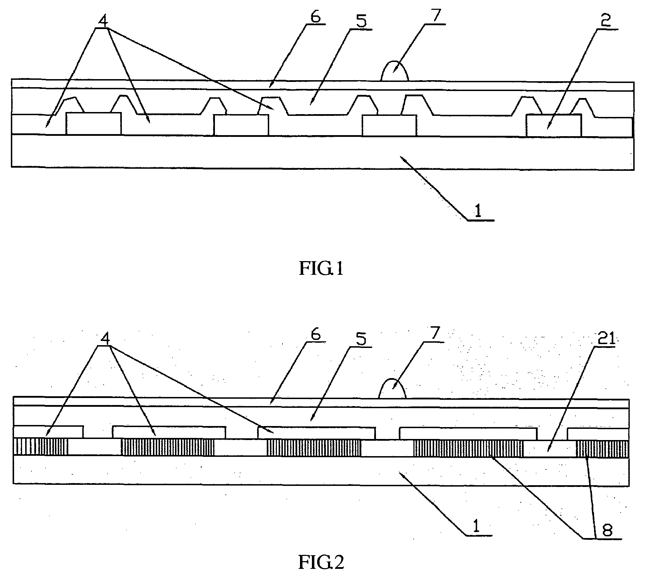

A TFT-LCD panel is made by assembling a color filter substrate and an array substrate facing each other. As shown in Fig. 1, it is a sectional view of a conventional color filter substrate. During the producing process of a TFT-LCD, the following method is often used to manufacture the conventional color filter substrate. First, a metal layer for manufacturing a black matrix (BM) 2 is formed on a glass substrate 1; a layer of photoresist (PR) is coated on the metal layer, the photoresist is exposed to obtain a photoresist pattern layer, and then the photoresist pattern layer is used as a mask for etching the metal layer to obtain a black matrix 2; next, a color filter layer 4, an overcoat 5, a transparent common electrode 6 and spacers 7 are formed in this order on the above structure. The color filter substrate formed with the above processes does not have the capability of polarizing, and a polarizer film is additionally attached on the external side of the glass substrate. Such a method of manufacturing a color filter substrate is complicate and time consuming and incurs high human and material costs. In the prior art from US 2009/290105 A1 it is known a liquid crystal apparatus including a plurality of dot regions, in which a polarization layer group constitutes of a plurality of polarization layers. From US 2006/061519 A1 it is known a small transparent display, in which a polarizer is fabricated on the silicon active backplane. US 2008/100779 A1 discloses a method of forming a wire grade polarizing pattern across the relatively large surface area of a display substrate.

### SUMMARY

One of the technical problem to be solved in the disclosure is about how to simplify the manufacturing steps of a color filter substrate and reduce the manufacturing costs.

One aspect of the disclosure provides a manufacturing method of a color filter substrate according to claim 1.

Another aspect of the disclosure also provides a color filter substrate capable of polarizing according to claim 6.

Further scope of applicability of the disclosed technology will become apparent from the detailed description given hereinafter. However, it should be understood that the detailed description and specific examples, while indicating preferred embodiments of the disclosed technology, are given by way of illustration only, since various changes and modifications within the spirit and scope of the disclosed technology will become apparent to those skilled in the art from the following detailed description.

### BRIEF DESCRIPTION OF THE DRAWINGS

The disclosed technology will become more fully understood from the detailed description given hereinafter and the accompanying drawings which are given by way of illustration only, and thus are not limitative of the disclosed technology and wherein:
Fig. 1 is a structure schematic view of color filter substrate in the prior art.
Fig. 2 is a cross sectional schematic view of a color filter substrate capable of polarizing in the embodiment of the disclosure.
Fig. 3 is a top view of a black matrix and a polarizing structure in the embodiment of the disclosure.

### DETAILED DESCRIPTION

The implementation of the disclosure will be described in detail below in conjunction with the drawings. The following embodiments are for purpose of illustrating the disclosure, but not limiting the scope of the disclosure.

A manufacturing method of a color filter substrate of the embodiment of the disclosure comprises the following steps.

Step 1, forming an intermediate layer for forming a black matrix on a base substrate.

The base substrate may be a glass substrate, a quartz substrate or a plastic substrate. The intermediate layer in this embodiment may be a metal layer, for example, an aluminum, chrome, gold or silver layer. The intermediate layer may also be a resin layer containing conductive materials, which may be metal wires, such as silver wires, aluminum wires and the like of nanometer size, or additives such as metal powders, such that the resultant polarizing structure has a certain electromagnetism characteristics. The intermediate layer is used to form the black matrix (BM) in subsequent steps.

Step 2, forming a photoresist layer on the intermediate layer.

Step 3, forming a photoresist pattern with a grating pattern of nanometer size with the photoresist layer.

For example, it is applicable to nano-imprint the photoresist layer by using a prefabricated die with a grating pattern of nanometer size by way of a nano-imprinting process. The die is fabricated in advance according to the grating pattern, composed of parallel slits, required for polarizing light. The regions of the photoresist layer corresponding to the regions other than the black matrix are imprinted with the grating pattern after the photoresist is nano-imprinted. The die may be made of quartz, glass or plastic material.

Step 4, etching the intermediate layer by using the photoresist pattern with a grating pattern of nanometer size as an etching mask to form a black matrix and a polarizing structure of a grating pattern in the intermediate layer as well.

The etching in this step may be a dry etching preferably. A wet etching or other etching method may also be applied in this step.

The resultant black matrix and the polarizing structure are formed on the glass substrate as a base substrate. The polarizing structure comprises a plurality of units which are located in respective pixel regions, which are arranged in an array, spaced from each other, and defined by the black matrix. The main structure parameters of the grating polarizer, i.e., the polarizing structure in the embodiment, comprise grating period, grating duty ratio, and grating depth. The critical parameter to determine the grating performance (TM transmittance and extinction ratio) is the relationship between the grating period and the wavelength of incident light. When the grating period is greater than the wavelength of incident light, the grating produces multiple-stage diffracted waves, and now the grating can be used as a diffraction grating but not a polarizer. When the grating period is much smaller than the wavelength of incident light, the grating only produces zero level diffracted wave, has strong polarization characteristics, with TM polarized light transmitting through and TE polarized light being reflected back, and may act as a polarizer with good performance. In an example, the grating period of grating pattern of the polarizing structure of this embodiment is between 60nm-300nm, the grating duty ratio is between 0.3-0.7, preferably is 0.5, and the grating depth is between 100nm-200nm, for polarizing the visual light. Thus the polarizing structure formed in the embodiment is capable of polarizing light, which ensures the display including the color filter substrate to function properly.

The method according to the embodiment, before or after step 4, may further comprises:
Step 4', forming a color filter layer.

If this step is performed before step 4, then the color filter layer, e.g., RGB (red; green; blue) sub-pixels layer is formed on the base substrate, and the black matrix and the polarizing structure are formed on the color filter layer. If this step is performed after step 4, then the black matrix and the polarizing structure are formed on the base substrate, and the color filter layer is formed on the black matrix and the polarizing structure. The RGB sub-pixels correspond to the sub-pixels defined by the black matrix. The formed color filter layer is not limited to such an RGB combination, but may also be for example CMYK (cyan; magenta; yellow; black) combination.

In the case of step 4' being performed after step 4, further, the color filter layer may be formed with an overcoat layer thereon, and this overcoat layer may be formed of a resin material. The overcoat layer is used to protect the color filter layer having an uneven surface and also used to provide an even upper surface so as to form the other structure layer(s) thereon.

Further, the overcoat layer may be formed with a transparent common electrode layer (e.g., ITO common electrode) thereon. In an application, if the transparent common electrode layer of a liquid crystal display of the mode of fringe-field switching (FFS) or in-plane switching (IPS) is formed on the array substrate, there is no need to form a transparent common electrode layer on the color filter substrate.

On the transparent common electrode layer or the overcoat layer without a transparent common electrode thereon, there may also be formed with post spacers which are used to maintain the space for the injection of liquid crystal after assembling the color filter substrate and the array substrate and keep the gap of the formed panel.

In another example, the spacers may also be located on the overcoat layer, projecting out of the transparent common electrode layer on the overcoat layer. Or the spacers may also be located on the color filter layer, projecting out of the transparent common electrode layer and the overcoat layer on the color filter layer. The spacers may also be located on the base substrate, projecting out of the black matrix or the polarizing structure, and the color filter layer, and further possibly out of the overcoat layer and the transparent common electrode layer, if they are formed.

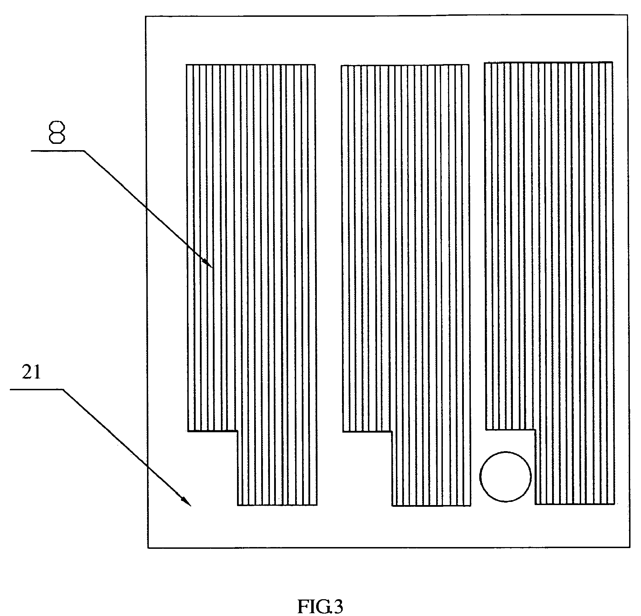

As shown in Fig. 2, a structure schematic view of a color filter substrate capable of polarizing in an embodiment of the disclosure is shown. Fig. 3 is a top view of a black matrix and a polarizing structure in the embodiment of the disclosure. As show in the drawings, a color filter substrate in this embodiment comprises a base substrate 1, a black matrix 21 formed on the base substrate 1, a polarizing structure 8 in the same layer with and preferably formed integrally with the black matrix 21. The polarizing structure 8 is located in the black matrix 2 and comprises a plurality of sub-pixels spaced from each other, and further comprises grating patterns of nanometer size side by side. A color filter layer 4 is formed above or below the black matrix 21 and the polarizing structure8. The color filter layer 4 comprises sub-pixels corresponding to the sub-pixels defined by the black matrix. When the color filter layer 4 is located above the black matrix 21, the color filter layer 4 may be formed with an overcoat layer 5 thereon, and the overcoat layer 5 may be formed with a transparent common electrode layer 6 thereon. There are spacers 7 formed on the base substrate 1, the color filter layer 4, the overcoat layer 5, or the transparent common electrode layer 6.

It can be seen from the above embodiment, the disclosure intends to form a black matrix and at the same time forms a polarizing structure capable of polarizing with an intermediate layer for forming the black matrix, by using photoresist pattern as a mask to etch the underlying intermediate layer (for example a metal layer or a resin layer), and the photoresist pattern is formed with a grating pattern of nanometer size. Consequently, the effect of display can be ensured while the step of attaching polarizer can be omitted, which save the time of process and reduce costs.

The embodiment of the disclosed technology being thus described, it will be obvious that the same may be varied in many ways. Such variations are not to be regarded as a departure from the spirit and scope of the disclosed technology, and all such modifications as would be obvious to those skilled in the art are intended to be comprised within the scope of the following claims.

## Claims

1. A manufacturing method of a color filter substrate comprising:
step 1, forming an intermediate layer containing conductor on a base substrate (1);
step 2, forming a photoresist layer on the intermediate layer and
step 3, forming the photoresist layer into a photoresist pattern with a grating pattern of nanometer size; **characterized in that** said manufacturing method comprises
step 4, using the photoresist pattern with the grating pattern of nanometer size to etch the underlying intermediate layer to form the intermediate layer into a black matrix (21) and a polarizing structure (8) having grating patterns, wherein the polarizing structure (8) and the black matrix (21) are made from the same materials as that of the intermediate layer, the intermediate layer comprises a resin layer containing conductive materials, wherein the conductive materials comprise metal wires or metal powders of nanometer size.

2. The manufacturing method of a color filter substrate according to claim 1, wherein the polarizing structure (8) comprises a grating pattern which is constructed of parallel slits, and the grating pattern has a grating period between 60nm-300nm, a grating duty ratio between 0.3-0.7, and a grating depth between 100nm-200nm.

3. The manufacturing method of a color filter substrate according to claim 2, wherein the grating duty ratio of the grating pattern of the polarizing structure (8) is 0.5.

4. The manufacturing method of a color filter substrate according to any of claims 1-3, wherein step 3 comprises using a die of grating pattern of nanometer size to nano-imprint the photoresist layer so as to imprint the grating pattern on regions in the photoresist layer corresponding to regions other than the black matrix (21) such that a photoresist pattern is obtained.

5. The manufacturing method of a color filter substrate according to any of claims 1-4, wherein before or after the step 4, further comprising:
step 4', forming a color filter layer (4).

6. A color filter substrate capable of polarizing comprising:
a base substrate (1), and
a black matrix (21) formed on the base substrate (1), and
a polarizing structure (8) on the base substrate (1) in the same layer with the black matrix (21), where the polarizing structure (8) comprises a plurality of regions spaced from each other and grating patterns of nanometer size side by side, **characterized in that** said polarizing structure (8) on the base substrate (1) is formed integrally in the same layer with the black matrix (21), wherein the polarizing structure (8) and the black matrix (21) are made from the same materials, the materials for forming the black matrix (21) and the polarizing structure (8) comprise a resin material containing conductive materials, wherein the conductive materials comprise metal wires or metal powders of nanometer size.

7. The color filter substrate capable of polarizing according to claim 68,
wherein the polarizing structure (8) has a grating pattern which is constructed of parallel slits, and the grating pattern has a grating period between 60nm-300nm, a grating duty ratio between 0.3-0.7, and a grating depth between 100nm-200nm.

8. The color filter substrate capable of polarizing according to claim 7, wherein the grating duty ratio of the grating pattern of the polarizing structure (8) is 0.5.

9. The color filter substrate capable of polarizing according to any of claims 6-8, further comprising a color filter layer (4) located above or below the black matrix (21) and the polarizing structure (8).

10. The color filter substrate capable of polarizing according to claim 9, further comprising an overcoat layer (5) formed on the color filter layer (4).

11. The color filter substrate capable of polarizing according to claim 10, further comprising a transparent common electrode (6) formed on the overcoat layer (5).

## Patentansprüche

1. Herstellungsverfahren für ein Farbfiltersubstrat, umfassend:
Schritt 1, Bilden einer Zwischenschicht, die elektrischen Leiter enthält,
auf einem Basissubstrat (1);
Schritt 2, Bilden einer Photoresist-Schicht auf der Zwischenschicht und
Schritt 3, Ausbilden einer Photoresist-Schicht in ein Photoresist-Muster mit einem Gittermuster von Nanometer-Größe;
**dadurch gekennzeichnet, dass** das Herstellungsverfahren umfasst Schritt 4, Verwendung des Photoresist-Musters mit dem Gittermuster von Nanometer-Größe, um die zugrunde liegende Zwischenschicht zu ätzen, um die Zwischenschicht in eine schwarze Matrix (21) und eine polarisierende Struktur (8), die Gittermuster aufweist, auszubilden, wobei die polarisierende Struktur (8) und die schwarze Matrix (21) aus den gleichen Materialien wie die Zwischenschicht hergestellt sind, wobei die Zwischenschicht eine Harzschicht, die elektrisch leitfähige Materialien enthält, umfasst, wobei die elektrisch leitfähigen Materialien Metalldrähte oder Metallpulver von Nanometer-Größe umfassen.

2. Herstellungsverfahren eines Farbfiltersubstrats gemäß Anspruch 1, wobei die polarisierende Struktur (8) ein Gittermuster umfasst, das aus parallelen Schlitzen konstruiert ist, und wobei das Gittermuster eine Gitterperiode zwischen 60 nm - 300 nm, ein Gitterverhältnis zwischen 0,3 - 0,7 und eine Gittertiefe zwischen 100 nm - 200 nm aufweist.

3. Herstellungsverfahren eines Farbfiltersubstrats gemäß Anspruch 2, wobei das Gitterverhältnis des Gittermusters der polarisierenden Struktur (8) 0,5 beträgt.

4. Herstellungsverfahren eines Farbfiltersubstrats gemäß einem der Ansprüche 1 bis 3, wobei Schritt 3 die Verwendung eines Werkzeuges des Gittermusters von Nanometer-Größe zum Nano-Einprägen der Photoresist-Schicht umfasst, um das Gittermuster auf Regionen in der Photoresist-Schicht einzuprägen, die anderen Regionen als der schwarzen Matrix (21) entsprechen, so dass ein Photoresist-Muster erhalten wird.

5. Herstellungsverfahren eines Farbfiltersubstrats gemäß einem der Ansprüche 1 bis 4, wobei das Verfahren vor oder nach dem Schritt 4 umfasst:
Schritt 4', Bilden einer Farbfilterschicht (4).

6. Polarisierfähiges Farbfiltersubstrat, umfassend:
ein Basissubstrat (1) und eine schwarze Matrix (21), die auf dem Basissubstrat (1) gebildet ist, und eine polarisierende Struktur (8) auf dem Basissubstrat (1) in der gleichen Schicht mit der schwarzen Matrix (21), wobei die polarisierende Struktur (8) eine Mehrzahl von voneinander beabstandeten Regionen und Gittermuster von Nanometer-Größe Seite an Seite umfasst,
**dadurch gekennzeichnet, dass** die polarisierende Struktur (8) auf dem Basissubstrat (1) mit der schwarzen Matrix (21) in der gleichen Schicht integral ausgebildet ist,
wobei die polarisierende Struktur (8) und die schwarze Matrix (21) aus den gleichen Materialien hergestellt sind, wobei die Materialien zur Bildung der schwarzen Matrix (21) und der polarisierenden Struktur (8) ein Harzmaterial, das elektrisch leitfähige Materialen enthält, umfassen,
wobei die elektrisch leitfähigen Materialien Metalldrähte oder Metallpulver von Nanometer-Größe umfassen.

7. Polarisierfähiges Farbfiltersubstrat gemäß Anspruch 6, wobei die polarisierende Struktur (8) ein Gittermuster aufweist, das aus parallelen Schlitzen konstruiert ist, und wobei das Gittermuster eine Gitterperiode zwischen 60 nm - 300 nm, ein Gitterverhältnis zwischen 0,3 - 0,7 und eine Gittertiefe zwischen 100 nm - 200 nm aufweist.

8. Polarisierfähiges Farbfiltersubstrat gemäß Anspruch 7, wobei das Gitterverhältnis des Gittermusters der polarisierenden Struktur (8) 0,5 beträgt.

9. Polarisierfähiges Farbfiltersubstrat gemäß einem der Ansprüche 6-8, außerdem umfassend eine Farbfilterschicht (4), die über oder unter der schwarzen Matrix (21) und der polarisierenden Struktur (8) angeordnet ist.

10. Polarisierfähiges Farbfiltersubstrat gemäß Anspruch 9, außerdem umfassend eine Überzugsschicht (5), die auf der Farbfilterschicht (4) gebildet ist.

11. Polarisierfähiges Farbfiltersubstrat gemäß Anspruch 10, außerdem umfassend eine transparente gemeinsame Elektrode (6), die auf der Überzugsschicht (5) gebildet ist.

## Revendications

1. Un procédé de fabrication d'un substrat de filtre de couleur, comprenant :
étape 1, former une couche intermédiaire contenant du conducteur sur un substrat de base (1) ;
étape 2, former une couche photosensible sur la couche intermédiaire et
étape 3, former la couche photosensible en un motif photosensible avec un motif de réseau de taille nanométrique ; **caractérisé en ce que** ledit procédé de fabrication comprend
étape 4, utiliser le motif photosensible avec le motif de réseau de taille nanométrique pour graver la couche intermédiaire sous-jacente pour changer la couche intermédiaire en une matrice noire (21) et une structure polarisante (8) ayant des motifs de réseau, dans lequel la structure polarisante (8) et la matrice noire (21) sont faites des mêmes matériaux que la couche intermédiaire, la couche intermédiaire comprenant une couche de résine contenant des matériaux conducteurs, dans lequel les matériaux conducteurs comprennent des fils métalliques ou des poudres métalliques de taille nanométrique.

2. Le procédé de fabrication d'un substrat de filtre de couleur selon la revendication 1, dans lequel la structure polarisante (8) comprend un motif de réseau lequel est formé de fentes parallèles, et le motif de réseau à une période de réseau entre 60nm et 300nm, un rapport cyclique de réseau entre 0,3 et 0,7 et une profondeur de réseau entre 100nm et 200nm.

3. Le procédé de fabrication d'un substrat de filtre de couleur selon la revendication 2, dans lequel le rapport cyclique de réseau du motif de réseau de la structure polarisante (8) est 0,5.

4. Le procédé de fabrication d'un substrat de filtre de couleur selon l'une quelconque des revendications 1 à 3, dans lequel l'étape 3 comprend l'utilisation d'une matrice de motif de réseau de taille nanométrique pour imprimer une empreinte nanométrique dans la couche photosensible de manière à imprimer le motif de réseau dans des régions de la couche photosensible correspondant à des régions autres que la matrice noire (21) de façon à obtenir un motif photosensible.

5. Le procédé de fabrication d'un substrat de filtre de couleur selon l'une quelconque des revendications 1 à 4, comprenant en outre avant ou après l'étape 4 :
étape 4', former une couche de filtre de couleur (4).

6. Un substrat de filtre de couleur capable de polariser, comprenant :
un substrat de base (1), et
une matrice noire (21) formée sur le substrat de base (1), et
une structure polarisante (8) sur le substrat de base (1) dans la même couche avec la matrice noire (21), dans lequel la structure polarisante (8) comprend une pluralité de régions espacées les unes des autres et des motifs de réseau de taille nanométrique côte à côte, **caractérisé en ce que** ladite structure polarisante (8) sur le substrat de base (1) est intégralement formée dans la même couche avec la matrice noire ((21), dans lequel la structure polarisante (8) et la matrice noire (21) sont faites des mêmes matériaux, les matériaux pour former la matrice noire (21) et la structure polarisante (8) comprenant un matériau de résine contenant des matériaux conducteurs, dans lequel les matériaux conducteurs comprennent des fils métalliques ou des poudres métalliques de taille nanométrique.

7. Le substrat de filtre de couleur capable de polariser selon la revendication 6, dans lequel la structure polarisante (8) a un motif de réseau qui est formé de fentes parallèles et le motif de réseau à une période de réseau entre 60nm et 300nm, un rapport cyclique de réseau entre 0,3 et 0,7 et une profondeur de réseau entre 100nm et 200nm.

8. Le substrat de filtre de couleur capable de polariser selon la revendication 7, dans lequel le rapport cyclique de réseau du motif de réseau de la structure polarisante (8) est 0,5.

9. Le substrat de filtre de couleur capable de polariser selon l'une quelconque des revendications 6 à 8, comprenant en outre une couche de filtre de couleur (4) situé au-dessus ou en-dessous de la matrice noire (21) et la structure polarisante (8).

10. Le substrat de filtre de couleur capable de polariser selon la revendication 9, comprenant en outre une couche de revêtement (5) formée sur la couche de filtre de couleur (4).

11. Le substrat de filtre de couleur capable de polariser selon la revendication 10, comprenant en outre une électrode commune transparente (6) formée sur la couche de revêtement (5).
